# EUROPÄISCHE PATENTSCHRIFT

(11) **EP 1 242 649 B1**
(45) Veröffentlichungstag und Bekanntmachung des Hinweises auf die Patenterteilung: **03.10.2012**
(21) Anmeldenummer: 00972632.4
(22) Anmeldetag: 11.10.2000
(51) Int. Cl.: C23C 16/513, C23C 4/12

(54) **VERFAHREN ZUR HERSTELLUNG VON KOMPOSITSCHICHTEN MIT EINER PLASMASTRAHLQUELLE**
METHOD FOR PRODUCING COMPOSITE LAYERS USING A PLASMA JET SOURCE
PROCEDE DE PRODUCTION DE COUCHES COMPOSITES AVEC UNE SOURCE DE JET DE PLASMA

(30) Priorität: 04.12.1999 DE 19958473
(43) Veröffentlichungstag der Anmeldung: 25.09.2002
(73) Patentinhaber: ROBERT BOSCH GMBH, 70442 Stuttgart (DE)
(72) Erfinder: GROSSE, Stefan, 70839 Gerlingen (DE); VOIGT, Johannes, 71229 Leonberg (DE)
(86) Internationale Anmeldenummer: PCT/DE2000/003566
(87) Internationale Veröffentlichungsnummer: WO 2001/040542

(56) Entgegenhaltungen:
- EP-A- 0 455 996
- EP-A- 0 481 722
- EP-A- 0 577 066
- WO-A-97/18341
- DE-A- 4 112 156
- PATENT ABSTRACTS OF JAPAN vol. 014, no. 397 (C-0752), 28. August 1990 (1990-08-28) & JP 02 149412 A (NAMIKI PRECISION JEWEL CO LTD), 8. Juni 1990 (1990-06-08)
- PATENT ABSTRACTS OF JAPAN vol. 017, no. 632 (C-1132), 24. November 1993 (1993-11-24) & JP 05 195107 A (TOYOTA MOTOR CORP), 3. August 1993 (1993-08-03)
- NOBUO KIEDA ET AL: "PREPARATION OF BATIO3 FILMS BY ICP FLASH EVAPORATION" JOURNAL OF THE CERAMIC SOCIETY OF JAPAN, INTERNATIONAL EDITION,FUJI TECHNOLOGY PRESS, TOKYO,JP, Bd. 101, Nr. 5, 1. Mai 1993 (1993-05-01), Seiten 551-555, XP000390677 ISSN: 0912-9200

## Beschreibung

Die Erfindung geht aus von einem Verfahren zur Herstellung von Kompositschichten mit einer Plasmastrahlquelle nach der Gattung des Hauptanspruchs.

### Stand der Technik

In vielen Industriezweigen besteht ein steigender Bedarf an dünnen, harten Schichten mit definierten physikalischen und chemischen Eigenschaften, die Bauteile oder Oberflächen von Werkstoffen vor Verschleiß oder Korrosion schützen sollen. Typische bekannte Schichten bestehen aus einer oder mehreren Lagen mit unterschiedlichen Zusammensetzungen, Qualitätsmerkmalen und Funktionalitäten.

Bei bekannten Plasmaspritzverfahren werden dazu im Grobvakuum bis hin zum atmosphärennahen Druckbereich bisher pulverförmige, mikroskalige Partikel in eine Plasmastrahlquelle oder einen Plasmastrahl eingeführt, dort angeschmolzen und teilweise verdampft, und dann mit hoher Geschwindigkeit gerichtet auf ein Substrat plattiert. Damit werden mit relativ hohen Abscheideraten Schichten mit unterschiedlichen Funktionalitäten abgeschieden, die jedoch nicht die Homogenität und Kompaktheit von typischen PACVD-Schichten (physically aided chemical vapour deposition) oder CVD-Schichten erreichen. Die Vorteile des Plasmaspritzens liegen andererseits in der stark lokalisierbaren Beschichtung und hohen Abscheideraten.

Die Erzeugung des Plasmastrahles beim Plasmaspritzen erfolgt üblicherweise mit Gleichspannung, Neuentwicklungen mit induktiver Hochfrequenzeinkopplung sind jedoch ebenfalls bereits bekannt. Letztere haben den Vorteil, daß die eingeführten Pulverpartikel eine längere Verweildauer in dem Plasmastrahl haben und damit stärker aufgeschmolzen werden.

So ist aus E. Pfender und C.H. Chang, "Plasma Spray Jets and Plasma-Particulate Interaction: Modelling and Experiments", Tagungsband des VI. Workshop Plasmatechnik, TU Illmenau, 1998, bekannt, in einer Plasmastrahlquelle über außen anliegende hochfrequente Wechselströme und eine induktive Hochfrequenzeinkopplung mit einer Spule in einem topfförmigen zylindrischen Brennerkörper ein Plasma zu erzeugen, das in Form eines Plasmastrahles aus der Plasmastrahlquelle austritt. Weiter ist daraus bekannt, als Plasmagas Helium, Argon oder Sauerstoff einzusetzen, dem weiterhin ein metallisches Pulver zugesetzt sein kann, so daß, analog dem bekannten Plasmaspritzen, ein oberflächliches Anschmelzen dieser Partikel im Plasmastrahl erfolgt, die dann außerhalb der Plasmaquelle auf einem Substrat abgeschieden werden.

Der Nachteil dieses Verfahrens ist zunächst die hohe Rauhigkeit und geringe mechanische Festigkeit der abgeschiedenen Schichten, was im wesentlichen darauf beruht, daß die zugeführten Pulverpartikel in dem Plasmastrahl aufgrund der hohen Strömungsgeschwindigkeit des Strahls nur kurze Zeit den hohen Plasmatemperaturen von teilweise mehr als 9000 K ausgesetzt sind, so daß sie nicht vollständig aufgeschmolzen, sondern oberflächlich lediglich angeschmolzen werden. Insbesondere findet kein Aufschmelzen und Auseinanderbrechen der zugeführten Partikel auf atomares bzw. molekulares Niveau oder auf die Ebene nanoskaliger Cluster statt. Als dünne Verschleißschutzschichten oder Hartstoffschichten mit Schichtdicken von einigen Mikrometern sind derartige Schichten somit vielfach ungeeignet. Weiterhin ist die Zusammensetzung der derart abgeschiedenen Schichten bisher im wesentlichen auf Metalle und Metalloxide beschränkt.

Weiter ist bekannt, dünne und hochwertige Verschleiß- und Korrosionsschutzzschichten aus der Gasphase im Hochvakuum mit PACVD-Prozessen ("physically aided chemical vapour deposition") oder PVD-Prozessen ("physical vapour deposition") abzuscheiden. PACVD- und CVD-Verfahren zeichnen sich durch qualitativ hochwertige, dichte, kompakte und homogene Schichten aus. Die Abscheiderate ist jedoch gering, da die Abscheidung durch atomares Wachstum erfolgt.

In S. Veprek, "Theoretisches Konzept für Design und praktische Darstellung neuartiger, thermodynamisch stabiler, superharter Kompositmaterialien", Statusseminar "Oberflächen- und Schichttechnologien", Würzburg, VDI-Technologiezentrum, 1997, Band 1, S. 27 und 28, wurde schließlich auf der Grundlage theoretischer Überlegungen vorgeschlagen, mit Hilfe eines Plasma-CVD- oder eines Plasma-PVD-Verfahrens neue superharte Schichten auf Substraten, insbesondere Stahlsubstraten, abzuscheiden. Diese Materialien werden durch Kombination eines nanokristallinen, harten Übergangsmetallnitrids MeₙN mit amorphem Si₃N₄ erzeugt. Die Abscheidung erfolgt bei 500°C bis 550°C. Weitere Details zu diesem Konzept werden in S. Veprek et al., Appl. Phys. Lett., 66, (1995), S. 2640 ff. vorgestellt.

Durch diese nanokristallinen Materialien in amorpher Matrix soll nach theoretischen Berechnungen teilweise die Härte von Diamant erreicht werden können.

Aus der WO 97/18341 ist es bekannt, eine flüssige Nanopartikelsuspension zur Erzeugung von nanostrukturierten Oberflächen auf ein Substrat aufzutragen. In einer Ausführungsform werden hierzu die Nanopartikel zusammen mit hohlen Mikrokugeln in ein Plasma eingebracht und auf ein Substrat aufgetragen.

### Vorteile der Erfindung

Das erfindungsgemäße Verfahren mit den kennzeichnenden Merkmalen des Hauptanspruchs hat gegenüber dem Stand der Technik den Vorteil, daß damit die bisher bestehende Lücke zwischen PACVD-Prozessen und Plasmaspritzprozessen geschlossen und gleichzeitig die Erzeugung innovativer Schichtsysteme und Materialien ermöglicht wird.

Im einzelnen wird dazu mit einer Plasmastrahlquelle in einer neuartigen Prozeßführung im Feinvakuum bis hin zum atmosphärennahen Druckbereich ein gerichteter, lokaler Beschichtungs- bzw. Abscheideprozeß auf einem Substrat ermöglicht, wobei die die Schicht bildenden Spezies (Precursoren) der Plasmastrahlquelle bzw. dem Plasma in Form von Pulvern zugeführt werden.

So werden einerseits feste Precursor-Materialien in Form von Nanopartikeln und mikroskaligen Pulvern der Plasmastrahlquelle zugeführt, die in dem Plasmastrahl je nach Verweildauer im Plasma bzw. je nach Ausgangsgröße der zugeführten Teilchen bzw. Pulverpartikel aufgeschmolzen, verdampft oder aufgebrochen werden, so daß einzelne Atome, Moleküle oder nano- bis mikroskalige Cluster bzw. Teilchen entstehen, die dann gerichtet und mit hoher Geschwindigkeit auf das zu beschichtende Substrat auftreffen.

Durch die Mischung unterschiedlicher Precursor-Materialien ist somit die Erzeugung neuartiger Materialien und Schichtsysteme möglich, wobei die Auswahl der verschiedenen Precursor-Materialien insbesondere derart erfolgt, daß diese in der Plasmastrahlquelle in unterschiedlicher Weise angeregt, aufgeschmolzen und/oder verdampft werden. Dies kann durch die Auswahl chemisch unterschiedlicher Precursor-Materialien, erreicht werden. Erfindungsgemäβ unterschoiden sich die eingesetzten Precursor-Materialien auch in ihrer Teilchengröße.

Insgesamt wird dadurch die Höhe und die Art des Energietransfers auf die zugeführten Teilchen bzw. Precursor-Materialien in dem Plasma gezielt beeinflußt, und es stellen sich unterschiedliche Anregungsgrade dieser zugeführten Spezies aufgrund unterschiedlicher Aufenthaltsdauern in heißeren oder kälteren Zonen des erzeugten Plasmas bzw. des sogenannten "Afterglows" ein.

Somit sind beispielsweise Schichtsysteme in Form von Kompositen darstellbar, die aus einer Mischung verschiedener Materialien bzw. Gefügezuständen bestehen, insbesondere einer Matrixstruktur und mindestens einer Einlagerung.

Der Kern des erfindungsgemäßen Verfahrens besteht demnach in der Darstellung von neuen Kompositschichtsystemen durch Verwendung von unterschiedlichen Precursor-Materialien in einer Plasmastrahlquellen mit definiert einstellbaren Prozeßbedingungen, so daß die verschiedenen, aufeinander abgestimmten Precursor-Materialien unterschiedlich prozessiert werden können. Damit hat man die Möglichkeit, neue, qualitativ hochwertige, teilweise harte bis superharte Schichtsysteme mit einstellbaren Eigenschaftsprofilen erzeugen zu können, wobei ein besonders wichtiger Vorteil des erfindungsgemäßen Verfahrens dessen Vielseitigkeit hinsichtlich der Abscheidung unterschiedlichster Schichtsysteme ist.

Daneben handelt es sich bei dem erfindungsgemäßen Verfahren um ein Verfahren mit gegenüber PACVD-Verfahren geringerem oder in speziellen Fällen sogar keinem Aufwand für die Vakuumtechnik, da ein Fein- oder Grobvakuum oder vielfach sogar der atmosphärennahe Druckbereich ausreichend ist. Gleichzeitig werden die Typischerweise hohen Gas- oder Partikelaustrittsgeschwindigkeiten von Plasmastrahlquellen genutzt, um einen effektiven Strom an Precursor-Material auf die zu beschichtende Oberfläche zu bringen, wodurch gegenüber CVD- oder PACVD-Verfahren deutlich höhere Schichtwachstumsraten erzielt werden.

Weiterhin ermöglicht das erfindungsgemäße Verfahren über eine Kombination verschiedener Precursor-Materialien auch die Abscheidung amorpher metallischer Legierungen, die in kristalliner Form nicht herstellbar sind, sowie neuartiger keramischer oder metall-keramischer Verbindungen. Zudem sind durch den Einsatz mehrerer Precursor-Materialien mit unterschiedlichen Verdampfungs- und Schmelztemperaturen auch anderer innovative Metallegierungen darstellbar.

Zudem ist man bei den eingesetzten Prozeßtemperaturen nun nicht mehr auf ein enges Temperaturfenster beschränkt, in dem beispielsweise ein thermodynamisches Gleichgewicht zugunsten der Bildung nanoskaliger Komposite anstelle der Bildung einer homogenen Legierung aus Einlagerungswerkstoff und Matrixwerkstoff vorliegt.

Vorteilhafte Weiterbildungen der Erfindung ergeben sich aus den in den Unteransprüchen aufgeführten Maßnahmen.

So kann zur Vermeidung von Kontaminationen und Abscheidungen sowie zur Verminderung der thermischen Belastung des Brennerkörpers und zur besseren Fokussierung des erzeugten Plasmastrahles innerhalb der Plasmastrahlquelle dem Brennerkörper zusätzlich ein das erzeugte Plasma zylindrisch umgebendes Hüllgas wie beispielsweise Wasserstoff oder Argon zugeführt werden.

Darüber hinaus können bei dem erfindungsgemäßen Verfahren Plasmastrahlquellen eingesetzt werden, die bei einem Druck von 10⁻⁴ mbar bis zu 1,5 bar im Prozeßraum arbeiten, wobei das Plasma auf verschiedenste, jeweils an sich bekannte Weise, beispielsweise über eine Gleichstromanregung, eine hochfrequente Wechselstromanregung, eine Mikrowellenanregung oder eine Anregung mit unipolaren oder bipolaren Spannungspulsen gezündet und aufrechterhalten werden kann.

Zudem ist es mit dem erfindungsgemäßen Verfahren nun möglich, unterschiedliche Schichtsysteme durch Veränderung der Schichtzusammensetzungen und/oder durch Variation der Schichtzusammensetzung als Funktion der Zeit herzustellen bzw. als Funktionsbeschichtung auf einem Substrat abzuscheiden. So kann beispielsweise über eine zeitliche Veränderung der Zusammensetzung der Precursor-Materialien in dem Plasma auch eine Abfolge von Teilschichten abgeschieden werden, die einen kontinuierlichen Übergang in der Materialzusammensetzung der Teilschichten aufweisen, und die beispielsweise aus einer Abfolge von Schichten.

Besonders vorteilhaft ist dabei, daß diese Abscheidung über einen weiten Temperaturbereich und auch insbesondere bei niedrigen Temperaturen erfolgen kann.

Auch die Darstellung von Schichten oder Schichtsystemen mit unterschiedlicher Morphologie und damit unterschiedlicher Eigenschaften selbst bei gleicher Materialzusammensetzung ist durch geeignete Wahl der Prozeßparameter möglich. Hierfür entscheidend sind die Menge der zugeführten Precursor-Materialien und deren Korngrößen sowie der Prozeßdruck und die Art, Zusammensetzung und Menge der zusätzlich zugeführten Gase (Injektorgas, Hüllgas, Zentralgas). Durch Wahl dieser Parameter sind amorphe, nano-, mikro bis hin zu gröber kristalline Phasen in den Kompositschichten darstellbar.

Ein weiterer Vorteil des erfindungsgemäßen Verfahrens ist die Möglichkeit, dieses zumindest zeitweilig mit einem an sich bekannten, separat ansteuerbaren CVD-, PVD- oder PACVD-Verfahren zu kombinieren, um damit Kombinationsschichten abzuscheiden. Dabei kann einerseits ein kontinuierlich betriebener CVD-, PVD- oder PACVD-Prozeß zeitweilig mit dem erfindungsgemäßen Verfahren kombiniert werden, andererseits kann aber auch das erfindungsgemäße Verfahren kontinuierlich betrieben werden, und diesem dann zumindest zeitweilig der CVD-, PVD- oder PACVD-Prozeß zugeschaltet werden. Auch der zyklische Einsatz beider Verfahren ist möglich.

Auf diese Weise kann weiter auf einem Substrat beispielsweise über einen an sich bekannten PACVD-Prozeß auch eine insbesondere amorphe Schicht als Matrixschicht abgeschieden werden, in die durch zyklisches Zuschalten des erfindungsgemäßen Verfahrens zusätzlich nanoskalige Partikel oder Kristallite eingebettet werden. Hierzu werden die zu beschichtenden Substrate bevorzugt zyklisch, beispielsweise durch Anordnung auf einem rotierbaren Träger, nacheinander an beispielsweise mindestens einer PACVD-Quelle und mindestens einer Plasmastrahlquelle vorbeigeführt, während die unterschiedlichen Quellen jeweils kontinuierlich arbeiten.

### Zeichnung

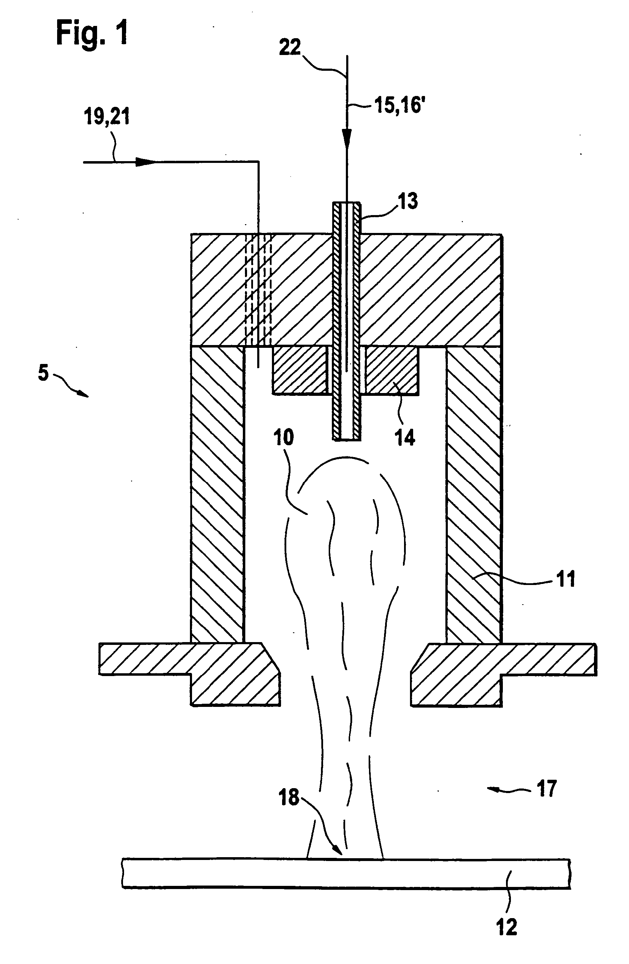

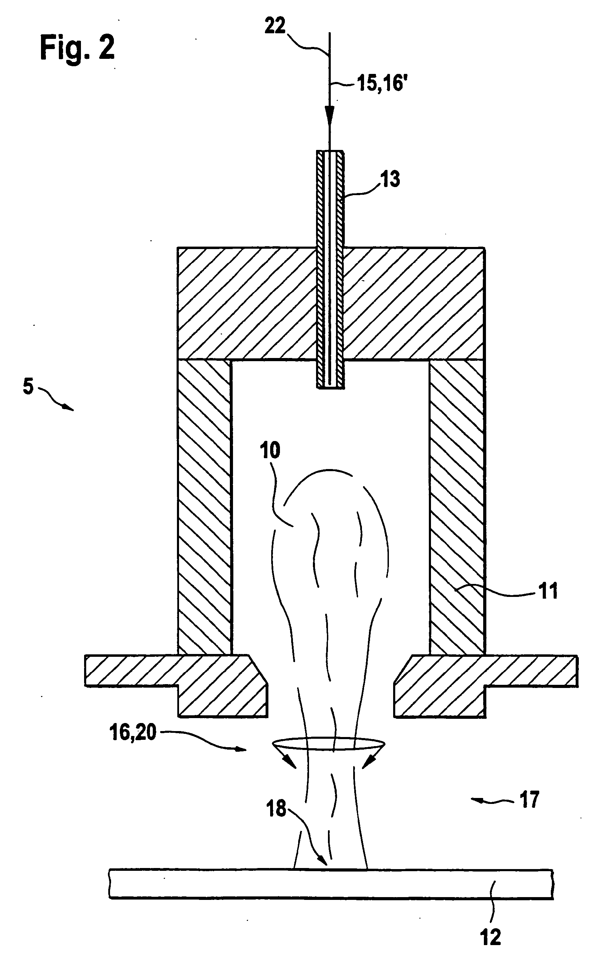

Ausführungsbeispiele der Erfindung werden anhand der Zeichnungen und in der nachfolgenden Beschreibung näher erläutert. Es zeigt Figur 1 eine aus dem Stand der Technik bekannte Plasmastrahlquelle zur Durchführung des erfindungsgemäßen Verfahrens und Figur 2 eine modifizierte Plasmastrahlquelle mit veränderter Gasführung.

### Ausführungsbeispiele

Zur Durchführung des erfindungsgemäßen Verfahrens eignet sich eine aus E. Pfender und C.H. Chang, "Plasma Spray Jets and Plasma-Particulate Interaction: Modelling and Experiments", Tagungsband des VI. Workshop Plasmatechnik, TU Illmenau, 1998, bekannte Plasmastrahlquelle 5.

Dieser Plasmastrahlquelle 5 mit einem zylindrischen Brennerkörper 11 wird gemäß Figur 1 über eine Zuführung 13 und eine zylindrische Hülse 14 ein Injektorgas 15 axial zugeführt wird. Mit dem Injektorgas 15 kann dabei optional auch ein Precursor-Material 16' zugeführt werden. In dem Brennerkörper 11 wird weiter über eine elektromagnetische Kopplung durch nicht dargestellte, an sich bekannte Bauteile ein Plasma 10 gezündet und kontinuierlich betrieben, welches in Form eines Plasmastrahles 17 aus dem Brennerkörper 11 der Plasmastrahlquelle 5 austritt. Der Brennerkörper 11 hat eine typische Höhe von ca. 10 cm. Der Plasmastrahl 17 trifft weiter in einer Entfernung von typischerweise ca. 10 cm bis 100 cm auf ein Substrat 12 wie Stahl auf, um dort eine Schicht oder ein Schichtsystem als Funktionsbeschichtung 18 abzuscheiden.

Weiterhin ist optional vorgesehen, ein Zentralgas 22 zentral innerhalb der Hülse 14 zuzuführen. Außerdem ist eine Gaszufuhr 21 in Form einer Gasdusche zur optionalen konzentrischen Einleitung eines Hüllgases 19 in den Brennerkörper 11 vorgesehen. Das Hüllgas 19 wird dazu außerhalb der Hülse 14 derart eingeleitet, daß es eine unerwünscht starke Aufheizung oder Beschichtung der Innenwände des Brennerkörpers 11 vermeidet. Darüber hinaus kann optional auch dem Hüllgas 19 ein Precursor-Material beigemischt sein.

Die Figur 2 zeigt eine Modifikation der Bauweise der Plasmastrahlquelle 5, wobei auf die Einleitung eines Hüllgases 19 und die Verwendung der Hülse 14 verzichtet wurde. In Figur 2 wird dem Plasma 10, das als Plasmastrahl 17 aus dem Brennerkörper 11 austritt, jedoch außerhalb der Plasmastrahlquelle 5 ein weiteres Precursor-Material 16 zugeführt. Dazu ist eine zusätzliche, den Plasmastrahl 17 konzentrisch umgebende Dusche 20 vorgesehen, die auch in eine am Ausgang der Plasmastrahlquelle 5, d.h. im Bereich des Austrittes des Plasmastrahles 17 aus dem Brennerkörper 11, angeordnete Düse integriert sein kann. Mit einem mit dieser Dusche 20 bzw. dieser Düse eingebrachten Precursor-Material 16 kann nachhaltig die Höhe und Art des Energietransfers vom Plasma 10 auf die Precursor-Materialien 16, 16' gesteuert werden, so daß unterschiedlich große Einlagerungen bzw. unterschiedlich strukturierte Einlagerungen in der abgeschiedenen Funktionsbeschichtung 18 realisierbar sind. Zur Steuerung dieses Energietransfers kann über die Dusche 20 dem Plasma weiter auch ein der Kühlung dienendes Quenchgas zugeführt werden.

Eine weitere Variante des erfindungsgemäßen Verfahrens sieht in Abwandlung von Figur 2 schließlich vor, auf eine axiale Injektion des ersten Precursor-Materials 16' in den Brennerkörper 11 zu verzichten, indem lediglich beispielsweise ein Edelgas wie Argon oder ein Reaktivgas wie Sauerstoff oder Wasserstoff in den Brennerkörper 11 als Injektorgas 15 eingeführt wird, das dann zunächst das Plasma 10 erzeugt, und dem dann außerhalb der Plasmastrahlquelle 5 ein oder mehrere Precursor-Materialien 16, beispielsweise in Form nanoskaliger oder mikroskaliger Pulver, über damit vermischte Trägergase mittels der konzentrischen Dusche 20 zugeführt werden.

Wesentlich für das erfindungsgemäße Verfahren ist stets, daß eine Wechselwirkung des Plasmas 10 mit den zugeführten Precursor-Materialien 16, 16' eintritt, wobei diese an- oder aufgeschmolzen, verdampft oder zumindest oberflächlich aktiviert oder fragmentiert werden. Bevorzugt ist ein Aufschmelzen oder Fragmentieren bis auf atomare bzw. molekulare Ebene (Atome, Moleküle, Radikale). Daneben kann diese Wechselwirkung auch in einer durch das Plasma 10 induzierten chemischen Reaktion des zugeführten Precursor-Materials 16, 16' mit einer ebenfalls zugeführten gasförmigen oder flüssigen Reaktionskomponente oder einem weiteren Precursor-Material bestehen.

Die Verfahrensparameter beim Betrieb der Plasmastrahlquelle 5, die der Fachmann im einzelnen für die jeweils abzuscheidende Funktionsbeschichtung über einfache Vorversuche ermitteln muß, sind die in das Plasma 10 eingekoppelte Leistung, die Art der Plasmaanregung im Brennerkörper 11, der Abstand zwischen der Austrittsöffnung des Brennerkörpers 11 und dem Substrat 12, die Art und Menge der zugeführten Precursor-Materialien 16, 16', sowie der Druck bei dem die Plasmastrahlquelle 5 betrieben wird. Insbesondere muß stets eine gewisse Mindestleistung in das Plasma 10 eingekoppelt werden, um eine erforderliche minimale Energiedichte zu gewährleisten, die dann wieder über Stöße und Strahlung an das schichtbildende Precursor-Material 16, 16' abgegeben wird. Außerdem kann über die Länge des Plasmastrahles 17 die Aufenthaltsdauer der eingebrachten Partikel bzw. Precursor-Materialien 16, 16' in den Plasmastrahl 17 beeinflußt werden, die wiederum während dieser Flugzeit Energie aus dem Plasmastrahl 17 aufnehmen. Erst wenn die Aufenthaltsdauer und damit die aufgenommene Energie ausreichend groß ist, ist beispielsweise ein vollständiges Aufbrechen eines eingebrachten Precursor-Materials 16, 16' bis auf die atomare oder molekulare Ebene gewährleistet.

Weitere Verfahrensparameter sind die Anzahl und Menge der zugeführten Precursor-Materialien 16, 16' und der Ort ihrer Zuführung, sowie die Art und Menge der eingesetzten Gase.

Die zugeführten Gase sind dabei entweder Inertgase wie Argon als Plasmagas bzw. Injektorgas 15 oder als Hüllgas 19, Trägergase wie Stickstoff oder Argon für die zugeführten Precursor-Materialien 16, 16', beispielsweise als Zentralgas 22, oder Reaktivgase wie Sauerstoff, Stickstoff, Ammoniak, Methan, Acetylen, Silan oder Wasserstoff als chemische Reagenz mit den zugeführten Precursor-Materialien 16, 16'.

Als Precursor-Materialien 16, 16' eignen sich Feststoff-Precursoren, die als submikro- oder nanoskalige Partikel aus Metallen wie Chrom, Titan, Eisen, Aluminium, Zirkonium, Hafnium o.ä., aus Hartstoffen bzw. Keramiken aus der Gruppe der Nitride, insbesondere der Bornitride, der Siliziumnitride oder der Metallnitride wie TiN, der Oxide wie Aluminiumoxid, Titandioxid oder Siliziumdioxid, der Carbide wie TiC, der Silizide oder der Siliziumverbindungen zugeführt werden.

Darüberhinaus können die Precursor-Materialien 16, 16' auch in Form von Suspensionen mit darin suspendierten nanoskaligen Partikeln aus obigen Materialklassen, zugeführt werden.

Im folgenden wird die erläuterte Erzeugung von Schichtsystemen als Funktionsbeschichtung 18 anhand einiger Beispiele im Detail näher ausgeführt.

Ein einem ersten nicht erfindungsgemäßen Beispiel werden dem Plasmastrahl 17 mindestens zwei unterschiedliche Precursor-Materialien 16, 16' zugeführt, von denen das eine gasförmig oder flüssig ist und dem Plasma 10 über die Zuführung 13 zugeführt wird, und wobei das zweite als Feststoff in Form eines nanoskaligen Pulvers oder einer Suspension eines nanoskaligen Pulvers über die Dusche 20 eingebracht wird. Dabei wird das gasförmige oder flüssige Precursor-Material 16' in dem Plasmastrahl 17 chemisch modifiziert und bildet bei der Abscheidung auf dem Substrat 12 eine zumindest weitgehend amorphe Schicht als Matrixschicht, während das zweite Precursor-Material 16 in dem Plasmastrahl 17 teilweise aufgeschmolzen wird und damit in der Funktionsbeschichtung 18 als Einlagerung in der Matrixschicht vorliegt. Mit den beiden unterschiedlichen Precursor-Materialien 16, 16' sind somit unterschiedliche Prozesse innerhalb des Plasmas 10 verknüpft, die gleichzeitig oder auch aufeinander abgestimmt nacheinander ablaufen können.

Ein zweites nicht erfindungsgemäßes Beispiel sieht, ansonsten analog dem ersten Beispiel, vor, als erstes Precursor-Material 16' flüssige oder gasförmige Kohlenwasserstoffe oder allgemein organische Ausgangsverbindungen einzusetzen, und als zweites Precursor-Material 16 Feststoffe aus Metallen oder Keramiken wie Ti, Cr, Ta, TiN, TiO₂, BN, SiN, SiC, TiC, ZrO₂, SiO₂, MoS₂ oder TaS₂ zu verwenden. Auf diese Weise lassen sich neuartige Funktionsbeschichtungen in Form von Verschleißschutzschichten, als Schichten zur Reibungsminderung, insbesondere in Form von Trockenschmierstoffen, oder für elektronische Anwendungen herstellen.

In einem dritten nicht erfindungsgemäßen Beispiel werden mindestens drei Precursor-Materialien 16, 16' eingesetzt, von denen das erste gasförmig oder flüssig ist, das zweite als Feststoff in Form eines nanoskaligen Pulvers oder einer Suspension eines nanoskaligen Pulvers eingebracht wird, und von denen das dritte als Reaktivgas, gegebenenfalls gemeinsam mit dem Hüllgas 19, über die Gaszufuhr 21 in das Plasma 10 eingebracht wird. Dabei wird das gasförmige oder flüssige erste Precursor-Material 16' zusammen mit dem dritten Precursor-Material in dem Plasmastrahl 17 chemisch umgesetzt und bildet bei der Abscheidung auf dem Substrat 12 zunächst eine zumindest weitgehend amorphe Schicht als Matrixschicht, in die das zweite, analog dem vorstehenden Beispiel über die Dusche 20 zugeführte Precursor-Material 16 eingebettet ist.

Im einzelnen eignen sich dazu als erstes Precursor-Material flüssige oder gasförmige Siliziumverbindungen wie Silane oder Silizium-Kohlenwasserstoff-Verbindungen, als zweites Precursor-Material nanoskalige Feststoffe aus Keramiken wie TiN, TiO₂, TaN, BN, TiC, Al₂O₃ oder ZrO₂, und als reaktives Plasmagas Stickstoff. Damit werden in besonders einfacher Weise neuartige superharte Funktionsbeschichtungen mit besonders hohen Schichthärten erzielt, beispielsweise eine nanoskalige TiN-Feststoffeinlagerung in einer dünnen Matrix aus einem demgegenüber elastischerem Material wie Si₃N₄.

Ein viertes erfindungsgemäßes Beispiel sieht vor, eine Hartstoffbeschichtung auf dem Substrat 12 zu erzeugen, indem dem Plasma 10 zumindest zwei Feststoff-Precursoren 16, 16' in Form von Pulvern oder Suspensionen zugeführt werden, wobei sich diese Pulver in ihrer Teilchengröße unterscheiden. Im einzelnen wird als erstes Precursor-Material 16' ein nanoskaliges Pulver oder eine Suspension eines nanoskaligen Pulvers eingesetzt, das in dem Plasmastrahl 17 bis auf atomares Niveau aufgebrochen bzw. aufgeschmolzen und auf dem Substrat 12 als zumindest weitgehend amorphe Matrixschicht abgeschieden wird, und als zweites Precursor-Material 16 ein mikroskaliges Pulver oder eine Suspension eines mikroskaligen Pulvers eingesetzt, das in dem Plasmastrahl 17 nicht vollständig aufgeschmolzen und damit in Form nanokristalliner oder mikrokristalliner Partikel in die gleichzeitig erzeugte amorphe Matrix eingebettet wird. Als erstes Precursor-Material 16' eignet sich dazu beispielsweise nanoskaliges TiN, das über die Zuführung 13 zusammen mit dem Trägergas Argon eingebracht wird, während als zweites Precursor-Material 16 mikroskaliges WC mit dem Trägergas Stickstoff über die Dusche 20 eingesetzt wird. Auf diese Weise werden hochduktile und verschleißfeste Hartstoff-Hartmetall-Schichten abgeschieden, wobei sich eine Matrix aus TiₓN_{y} bildet, deren Zusammensetzung über die Prozeßbedingungen, insbesondere über die Gasflüsse steuerbar ist.

In einem fünften erfindungsgemäßes Beispiel werden dem Plasma 10 zumindest zwei Precursor-Materialien 16, 16' zugeführt, die sich hinsichtlich ihrer Verdampfungs- und Schmelztemperaturen unterscheiden. So wird beispielsweise erstes Precursor-Material 16' pulverförmiges Titan und als zweites Precursor-Material 16 pulverförmiges SiN eingesetzt, wobei jedoch das zugeführte Titan in dem Plasma 10 stärker aktiviert wird als SiN, so daß sich eine hochduktile keramische Beschichtung mit - abhängig von den Prozeßbedingungen - metallischem, stark unterstöchiometrischem TiSiₓN_{y} mit x, y << 1 oder keramischem TiSiN als Matrixwerkstoff bildet.

Ein sechstes nicht erfindungsgemäßen Beispiel sieht vor, daß als ein erstes Precursor-Material 16' über die Zuführung 13 dem Plasma 10 Acetylen oder Methan zugeführt wird, das in Form einer amorphen Kohlenstoff-Matrixschicht auf dem Substrat 12 Atom für Atom aufgebaut wird. Gleichzeitig wird als zweites Precursor-Material 16 über die Dusche 20 oder alternativ ebenfalls über die Zuführung 13 ein mikroskaliges oder nanoskaliges TiN-Pulver in das Plasma 10 eingebracht. Dabei wird die Oberfläche dieser Pulverpartikel lediglich angeschmolzen und gleichzeitig chemisch aktiviert, so daß sie als nanoskalige oder mikroskalige Kristallite in der gleichzeitig abgeschiedenen amorphen Matrixschicht, die als Skelett dient, eingebettet sind.

Die gleichzeitige Abscheidung einer Matrixschicht und darin eingebetteter Partikel als Funktionsbeschichtung 18 auf dem Substrat 12 mit der Plasmastrahlquelle 5 wird weiter in einem siebten Ausführungsbeispiel erläutert. Dazu wird beispielsweise über die Zuführung 13 als Precursor-Material 16' das Reaktivgas Sauerstoff eingesetzt, während über die Gaszufuhr 21 ein mikroskaliges oder nanoskaliges Metallpulver wie TiN-Pulver gemeinsam mit einem Trägergas in das erzeugte Sauerstoff-Plasma eingebracht wird. In diesem Plasma 10 bzw. in dem Plasmastrahl 17 wird somit von den TiN-Pulverpartikeln über hochenergetische Gasbestandteile einerseits das Metall, im konkreten Fall Titan, zumindest teilweise abgesputtert, das im weiteren mit dem zugeführten Sauerstoff zu einem Metalloxid bzw. einem Titanoxid reagiert. Gleichzeitig kann durch geeignete Wahl der Gasflüsse und des Abstandes von Brennerkörper 11 und Substrat 12 erreicht werden, daß auch noch angeschmolzene Reste des zugeführten Precursor-Materials 16' in Form von nanoskaligen oder mikroskaligen Kristalliten in die aufwachsende Matrixschicht eingebettet werden, so daß im konkreten Beispiel eine TiO₂-Matrixschicht mit eingebetteten TiN-Kristalliten entsteht.

Weitere typische Beispiele für derartige, besonders harte Funktionsbeschichtungen 18 sind TiN-Partikel in einer Siliziumoxid-Matrix, oder Titanborid-, Titanoxid- oder Chromborid-Partikel in DLC (diamond-like carbon).

Im übrigen kann in Abwandlung des vorstehenden Beispiels das Precursor-Material auch als Gas oder Flüssigkeit in das Plasma 10 bzw. den Plasmastrahl 17 eingebracht werden, wobei dann in dem Plasma über Stöße und chemische Reaktionen der entstehenden Gas- oder Flüssigkeitsmoleküle Cluster oder Nanopartikel gebildet werden, die eine angeregte Oberfläche aufweisen, und sich damit sehr haftfest in die gleichzeitig abgeschiedene amorphe Matrixschicht einbetten werden.

Den vorstehend erläuterten Bespielen ist jeweils gemeinsam, daß in der Plasmastrahlquelle 5 durch induktiv eingekoppelte Hochfrequenz und unter Zufuhr eines Injektorgases 15 wie Sauerstoff, oder Wasserstoff in dem Brennerkörper 11 ein Plasma 10 erzeugt wird. Die eingekoppelte Leistung beträgt dabei typischerweise ca. 20 kW, der Druck ca. 200 mbar, der Gasfluß des Injektorgases 15 ca. 5 SLpM (standard liter per minute), der Fluß des optionalen Zentralgases 22 und des optionalen Hüllgases 19, für die beispielsweise Stickstoff, Argon oder Wasserstoff eingesetzt werden, ca. 20 bzw. 70 SLpM, und der Abstand zwischen der Austrittsöffnung des Brennerkörpers 11 und dem Substrat ca. 20 cm.

Daneben wird in dem Fall, daß ein gasförmiges Precursor-Material 16' über die Zuführung 13 eingeleitet wird, ein typischer Gasfluß von 5 SLpM eingesetzt.

Bei der Abscheidung von Kompositschichten als Funktionsbeschichtung 18 hat sich weiter herausgestellt, daß dazu über Hochfrequenzeinkopplung angeregte Plasmen 10 gegenüber DC-Verfahren (Gleichstrom) wie beispielsweise Hochgeschwindigkeitsflammspritzen besonders geeignet sind. In diesem Fall ist die Verweildauer der dem Plasma 10 zugeführten Precursor-Materialien 16, 16' besonders lang, so daß damit eine hohe Effizienz der chemischen Modifikation oder des Aufschmelzens von in Form von Pulvern oder Suspensionen zugeführten Precursor-Materialien 16, 16' erreicht wird.

Da je nach Wahl des Injektorgases 15 eine chemische Reaktion dieses Gases mit den Precursor-Materialien 16, 16' und/oder ein Aufschmelzen der Precursor-Materialien 16, 16' stattfindet, kann über die Wahl des Injektorgases 15 die Zusammensetzung der Funktionsbeschichtung 18 besonders einfach gezielt beeinflußt werden.

Schließlich sei betont, daß die vorstehenden Ausführungsbeispiele nicht beschränkt sind hinsichtlich der konkreten Form der Precursor-Materialien 16 bzw. 16'. Diese sind pulverförmig, und können auch aus einer Mischung verschiedener Precursor-Materialien bestehen. Dabei ist auch eine zusätzliche Zufuhr einer Suspension, eines Pulvers oder einer Pulvermischung als Precursor-Material 16 über die Dusche 20 oder die Zuführung 13 in den Plasmastrahl 17 oder das Plasma 10 möglich.

Weitere Ausführungsbeispiele der Erfindung sehen vor, die vorstehenden Ausführungsbeispiele zur Erzeugung der Funktionsbeschichtung 18 mit einer Abscheidung mit einem herkömmlichen CVD-Prozeß (chemical vapour deposition) oder einem herkömmlichen PVD-Prozeß (physical vapour deposition) zu kombinieren. Dazu wird eine separat ansteuerbare CVD- oder PVD-Vorrichtung zumindest zeitweise gemeinsam oder alternierend mit der Plasmastrahlquelle 5 zur Abscheidung der Funktionsbeschichtung 18 betrieben. Damit läßt sich beispielsweise über die CVD-Vorrichtung in bekannter Weise eine amorphe Matrix-Schicht auf dem Substrat 12 abscheiden, in der mittels der Plasmastrahlquelle 5 in den vorstehend erläuterten Weisen über zugeführte Precursor-Materialien Einlagerungen erzeugt werden.

So kann beispielsweise ein CVD-Prozeß kontinuierlich betrieben werden, während lediglich zeitweise die Plasmastrahlquelle 5 zugeschaltet wird, oder umgekehrt.

## Patentansprüche

1. Verfahren zur Erzeugung von Funktionsbeschichtungen, insbesondere von Kompositschichten oder Metalllegierungen, auf einem Substrat (12) mit mindestens einer im Feinvakuum bis zum atmosphärennahen Druckbereich betreibbaren Plasmastrahlquelle (5), die ein Plasma (10) erzeugt, das in Form eines Plasmastrahles (17) aus der Plamastrahlquelle (5) austritt und auf das Substrat (12) einwirkt, wobei dem Plasma (10) mindestens ein erstes und ein zweites Precursor-Material (16, 16') zugeführt werden, die in dem Plasmastrahl (17) modifiziert oder aufgeschmolzen und danach auf dem Substrat (12) abgeschieden werden, wobei auf dem Substrat (12) eine zumindest weitgehend amorphe Matrixschicht mit darin enthaltenen nanoskaligen oder mikroskaligen Einlagerungen oder Kristalliten abgeschieden wird, **dadurch gekennzeichnet, dass** das erste Precursor-Material ein nanoskaliges Pulver oder eine Suspension eines nanoskaligen Pulvers ist und das zweite Precursor-Material ein mikroskaliges Pulver oder eine Suspension eines mikroskaligen Pulvers ist, wobei das erste und das zweite Precursor-Material (16, 16') sich hinsichtlich ihrer Verdampfungstemperatur und/oder Schmelztemperatur unterscheiden.

2. Verfahren nach Anspruch 1, **dadurch gekennzeichnet, dass** mindestens ein Precursor-Material (16, 16') in dem Plasmastrahl (17) zumindest teilweise ionisiert und/oder chemisch aktiviert wird, und/oder dass mindestens ein Precursor-Material (16, 16') in dem Plasma (10) einer chemischen Reaktion unterzogen wird.

3. Verfahren nach Anspruch 1 oder 2, **dadurch gekennzeichnet, dass** in die Plasmastrahlquelle (5) über mindestens eine Zuführung (13) ein Gas (15, 19, 22) eingeleitet wird, wobei das Gas (15, 19, 22) ein Trägergas für ein Precursor-Material (16, 16'), insbesondere Stickstoff, ein Inertgas, insbesondere Argon, ein Reaktivgas für eine chemische Reaktion mit einem Precursor-Material (16, 16'), insbesondere Sauerstoff, Stickstoff, Ammoniak, Silan, Acetylen, Methan oder Wasserstoff, oder eine Mischung aus diesen Gasen ist.

4. Verfahren nach Anspruch 1 oder 2, **dadurch gekennzeichnet, dass** in die Plasmastrahlquelle (5) ein das Plasma (10) zumindest bereichsweise zylindrisch umgebendes Hüllgas (19), insbesondere ein Inertgas wie Argon, eingeleitet wird.

5. Verfahren nach mindestens einem der vorangehenden Ansprüche, **dadurch gekennzeichnet, dass** mindestens ein Precursor-Material (16) über eine außerhalb der Plasmastrahlquelle (5) angeordnete, den Plasmastrahl (17) insbesondere konzentrisch umgebende Dusche (20) oder mittels einer in einer Umgebung des Austrittes des Plamastrahls (17) aus der Plasmastrahlquelle (5) angeordnete Düse dem Plasmastrahl (17) zugeführt wird.

6. Verfahren nach mindestens einem der vorangehenden Ansprüche, **dadurch gekennzeichnet, dass** als Beschichtung (18) auf dem Substrat (12) eine Schicht oder eine Abfolge von Schichten abgeschieden wird, die aus einem Metallsilizid, einem Metallcarbid, Siliziumcarbid, einem Metalloxid, einem Siliziumoxid, einem Metallnitrid, Siliziumnitrid, einem Metallborid, einem Metallsulfid, amorphem Kohlenstoff, einer Kohlenwasserstoff-Verbindung oder aus einer Mischung dieser Materialien besteht.

7. Verfahren nach mindestens einem der vorangehenden Ansprüche, **dadurch gekennzeichnet, dass** über eine zeitliche Veränderung der Zusammensetzung mindestens eines Precursor-Materials (16, 16') eine Abfolge von Schichten als Beschichtung (18) auf dem Substrat (12) abgeschieden wird.

8. Verfahren nach mindestens einem der vorangehenden Ansprüche, **dadurch gekennzeichnet, dass** mindestens ein erstes Precursor-Material (16, 16') eine Siliziumverbindung oder eine Silizium-Kohlenwasserstoff-Verbindung ist, und dass mindestens ein zweites Precursor-Material (16, 16') einen nanoskaligen keramischen Feststoff, insbesondere TiN, TiO₂, TaN, BN, TiC, Al₂O₃ oder ZrO₂, enthält, und dass dem Plasma (10) als Reaktivgas Stickstoff zugeführt wird.

9. Verfahren nach mindestens einem der vorangehenden Ansprüche, **dadurch gekennzeichnet, dass** das erstes Precursor-Material auf dem Substrat (12) als zumindest weitgehend amorphe Matrixschicht abgeschieden wird, und dass das zweites Precursor-Material ein mikroskaliges Pulver ist, das in dem Plasma (10) nicht vollständig aufgeschmolzen und in Form nanokristalliner oder mikrokristalliner Partikel in der amorphen Matrixschicht eingebettet abgeschieden wird.

10. Verfahren nach mindestens einem der vorangehenden Ansprüche, **dadurch gekennzeichnet, dass** das erste Precursor-Material nanoskaliges, pulverförmiges TiN und das zweite Precursor-Material mikroskaliges, pulverförmiges WC enthält, wobei als Trägergase Stickstoff und/oder Argon eingesetzt werden.

11. Verfahren nach mindestens einem der vorangehenden Ansprüche, **dadurch gekennzeichnet, dass** das nanoskalige Precursor-Material dem Plasma (10) über die Zuführung (13) zugeführt wird, und dass das mikroskalige Precursor-Material dem Plasma (10) über die Dusche (20) zugeführt wird.

12. Verfahren nach mindestens einem der vorangehenden Ansprüche, **dadurch gekennzeichnet, dass** eine Funktionsbeschichtung (18) abgeschieden wird, die eine Matrixschicht mit Einlagerungen aufweist, wobei die Matrixschicht aus gegenüber den Einlagerungen elastischerem Material, insbesondere über- oder unterstöchiometrischem Si₃N₄, besteht.

13. Verfahren nach mindestens einem der vorangehenden Ansprüche, **dadurch gekennzeichnet, dass** die Erzeugung der Funktionsschicht (18) mit der Plasmastrahlquelle (5) zumindest zeitweilig unter Zuschaltung eines CVD-Prozesses, eines PCD-Prozesses oder eines PACVD-Prozesses, insbesondere zur Abscheidung einer amorphen Matrixschicht, erfolgt, oder dass die Erzeugung der Funktionsschicht (18) mit einem CVD-Prozess, einem PCD-Prozess oder einem PACVD-Prozess erfolgt, dem zumindest zeitweilig eine Abscheidung mit der Plasmastrahlquelle (5) zugeschaltet wird.

14. Verfahren nach mindestens einem der vorangehenden Ansprüche, **dadurch gekennzeichnet, dass** die Plasmastrahlquelle (5) und eine für den CVD-prozess, den PVD-Prozess oder den PACVD-Prozess vorgesehene separate Abscheidevorrichtung kontinuierlich betrieben werden, wobei das Substrat (12) zwischen der Plasmastrahlquelle (5) und der Abscheidevorrichtung bewegt wird.

## Claims

1. Method for producing functional coatings, in particular composite layers or metal alloys, on a substrate (12) using at least one plasma jet source (5) which can be operated in a fine vacuum up to an almost atmospheric pressure range and produces a plasma (10) which is discharged from the plasma jet source (5) in the form of a plasma jet (17) and acts on the substrate (12), wherein at least a first and a second precursor material (16, 16') are fed to the plasma (10) and are modified or fused in the plasma jet (17) and then deposited on the substrate (12), wherein an at least largely amorphous matrix layer with nanoscale or microscale intercalations or crystallites contained therein is deposited on the substrate (12), **characterized in that** the first precursor material is a nanoscale powder or a suspension of a nanoscale powder and the second precursor material is a microscale powder or a suspension of a microscale powder, wherein the first and the second precursor materials (16, 16') differ in terms of the evaporation temperature and/or melting temperature thereof.

2. Method according to Claim 1, **characterized in that** at least one precursor material (16, 16') is at least partially ionized and/or chemically activated in the plasma jet (17), and/or **in that** at least one precursor material (16, 16') is subjected to a chemical reaction in the plasma (10).

3. Method according to Claim 1 or 2, **characterized in that** a gas (15, 19, 22) is introduced into the plasma jet source (5) via at least one feed (13), wherein the gas (15, 19, 22) is a carrier gas for a precursor material (16, 16'), in particular nitrogen, an inert gas, in particular argon, a reactive gas for a chemical reaction with a precursor material (16, 16'), in particular oxygen, nitrogen, ammonia, silane, acetylene, methane or hydrogen, or a mixture of these gases.

4. Method according to Claim 1 or 2, **characterized in that** an enveloping gas (19), in particular an inert gas such as argon, which cylindrically surrounds the plasma (10) at least in certain regions is introduced into the plasma jet source (5).

5. Method according to at least one of the preceding claims, **characterized in that** at least one precursor material (16) is fed to the plasma jet (17) via a shower (20) which is arranged outside the plasma jet source (5) and surrounds the plasma jet (17), in particular concentrically, or by means of a nozzle which is arranged in an area surrounding the discharge of the plasma jet (17) from the plasma jet source (5).

6. Method according to at least one of the preceding claims, **characterized in that** the coating (18) deposited on the substrate (12) is a layer or a sequence of layers consisting of a metal silicide, a metal carbide, silicon carbide, a metal oxide, a silicon oxide, a metal nitride, silicon nitride, a metal boride, a metal sulphide, amorphous carbon, a hydrocarbon compound or of a mixture of these materials.

7. Method according to at least one of the preceding claims, **characterized in that** a sequence of layers is deposited as a coating (18) on the substrate (12) via a time-wise change in the composition of at least one precursor material (16, 16').

8. Method according to at least one of the preceding claims, **characterized in that** at least a first precursor material (16, 16') is a silicon compound or a silicon-hydrocarbon compound, and **in that** at least a second precursor material (16, 16') contains a nanoscale ceramic solid, in particular TiN, TiO₂, TaN, BN, TiC, Al₂O₃ or ZrO₂, and **in that** nitrogen is fed to the plasma (10) as reactive gas.

9. Method according to at least one of the preceding claims, **characterized in that** the first precursor material is deposited on the substrate (12) as an at least largely amorphous matrix layer, and **in that** the second precursor material is a microscale powder which is not completely fused in the plasma (10) and is deposited in the form of nanocrystalline or microcrystalline particles embedded in the amorphous matrix layer.

10. Method according to at least one of the preceding claims, **characterized in that** the first precursor material contains nanoscale, pulverulent TiN and the second precursor material contains microscale, pulverulent WC, wherein nitrogen and/or argon are used as carrier gases.

11. Method according to at least one of the preceding claims, **characterized in that** the nanoscale precursor material is fed to the plasma (10) via the feed (13), and **in that** the microscale precursor material is fed to the plasma (10) via the shower (20).

12. Method according to at least one of the preceding claims, **characterized in that** a functional coating (18) having a matrix layer with intercalations is deposited, wherein the matrix layer consists of material which is more elastic than the intercalations, in particular hyperstoichiometric or hypostoichiometric Si₃N₄.

13. Method according to at least one of the preceding claims, **characterized in that** the functional layer (18) is produced using the plasma jet source (5) at least intermittently while switching in a CVD process, a PCD process or a PACVD process, in particular for depositing an amorphous matrix layer, or **in that** the functional layer (18) is produced using a CVD process, a PCD process or a PACVD process into which deposition using the plasma jet source (5) is switched at least intermittently.

14. Method according to at least one of the preceding claims, **characterized in that** the plasma jet source (5) and a separate deposition apparatus provided for the CVD process, the PVD process or the PACVD process are operated continuously, wherein the substrate (12) is moved between the plasma jet source (5) and the deposition apparatus.

## Revendications

1. Procédé pour former sur un substrat (12) des revêtements fonctionnels, en particulier des couches de composite ou d'alliage métallique, à l'aide d'au moins une source (5) de faisceau plasma qui est apte à fonctionner depuis un vide poussé jusqu'à une plage de pression proche de la pression atmosphérique et qui forme un plasma (10) qui sort de la source (5) de faisceau plasma sous la forme d'un faisceau plasma (17) qui agit sur le substrat (12),
au moins un premier et un deuxième matériau précurseur (16, 16') étant apportés dans le plasma (10), modifiés dans le faisceau plasma (17), fondus et ensuite déposés sur le substrat (12),
une couche de matrice au moins largement amorphe et contenant des dépôts ou cristallites à l'échelle nanoscopique ou microscopique étant déposée sur le substrat (12),
**caractérisé en ce que**
le premier matériau précurseur est une poudre nanoscopique ou une suspension de poudre nanoscopique,
**en ce que** le deuxième matériau précurseur est une poudre microscopique ou une suspension de poudre microscopique et
**en ce que** le premier et le deuxième matériau précurseur (16, 16') diffèrent l'un de l'autre par leur température de vaporisation et/ou leur température de fusion.

2. Procédé selon la revendication 1, **caractérisé en ce qu'**au moins un matériau précurseur (16, 16') est au moins partiellement ionisé et/ou activé chimiquement dans le faisceau plasma (17) et/ou **en ce qu'**au moins un matériau précurseur (16, 16') subit une réaction chimique dans le plasma (10).

3. Procédé selon les revendications 1 ou 2, **caractérisé en ce qu'**un gaz (15, 19, 22) est apporté dans la source (5) de faisceau plasma par au moins une amenée (13), le gaz (15, 19, 22) étant un gaz porteur d'un matériau précurseur (16, 16'), en particulier l'azote, un gaz inerte, notamment l'argon, un gaz réactif assurant une réaction chimique avec un matériau précurseur (16, 16'), notamment l'oxygène, l'azote, l'ammoniac, un silane, l'acétylène, le méthane ou l'hydrogène, ou un mélange de ces gaz.

4. Procédé selon les revendications 1 ou 2, **caractérisé en ce qu'**un gaz d'enveloppe (19), en particulier un gaz inerte tel que l'argon, qui entoure cylindriquement au moins certaines parties du plasma (10), est introduit dans la source (5) de faisceau plasma.

5. Procédé selon au moins l'une des revendications précédentes, **caractérisé en ce qu'**au moins un matériau précurseur (16) est apporté dans le faisceau plasma (17) par une douche (20) disposée à l'extérieur de la source (5) de faisceau plasma et qui entoure le faisceau plasma (17) en particulier de manière concentrique ou au moyen d'une tuyère disposée au voisinage de l'emplacement par lequel le faisceau plasma (17) sort de la source (5) de faisceau plasma.

6. Procédé selon au moins l'une des revendications précédentes, **caractérisé en ce que** comme revêtement (18), on dépose sur le substrat (12) une couche ou une succession de couches constituée d'un siliciure de métal, d'un carbure de métal, d'un carbure de silicium, d'un oxyde de métal, d'un oxyde de silicium, d'un nitrure de métal, d'un nitrure de silicium, d'un borure de métal, d'un sulfure de métal, de carbone amorphe, d'un composé hydrocarboné ou d'un mélange de ces matériaux.

7. Procédé selon au moins l'une des revendications précédentes, **caractérisé en ce que** la succession de couches est déposée comme revêtement (18) sur le substrat (12) en modifiant dans le temps de la composition d'au moins un matériau précurseur (16, 16').

8. Procédé selon au moins l'une des revendications précédentes, **caractérisé en ce qu'**au moins un premier matériau précurseur (16, 16') est un composé du silicium ou un composé de silicium et d'hydrocarbure, **en ce qu'**au moins un deuxième matériau précurseur (16, 16') contient un solide céramique nanoscopique, en particulier TiN, TiO₂, TaN, BN, TiC, Al₂O₃ ou ZrO₂, et **en ce que** de l'azote est apporté comme gaz réactif au plasma (10).

9. Procédé selon au moins l'une des revendications précédentes, **caractérisé en ce que** le premier matériau précurseur est déposé sur le substrat (12) sous la forme d'au moins une couche de matrice largement amorphe et **en ce que** le deuxième matériau précurseur est une poudre microscopique qui n'est pas fondue complètement dans le plasma (10) et qui est déposée et incorporée dans la couche de matrice amorphe sous la forme de particules nanocristallines ou microcristallines.

10. Procédé selon au moins l'une des revendications précédentes, **caractérisé en ce que** le premier matériau précurseur contient du TiN poudreux nanoscopique et le deuxième matériau précurseur du WC poudreux microscopique, les gaz porteurs étant l'azote et/ou l'argon.

11. Procédé selon au moins l'une des revendications précédentes, **caractérisé en ce que** le matériau précurseur nanoscopique est apporté au plasma (10) par l'amenée (13) et **en ce que** le matériau précurseur microscopique est apporté au plasma (10) par la douche (20).

12. Procédé selon au moins l'une des revendications précédentes, **caractérisé en ce qu'**un revêtement fonctionnel (18) qui présente une couche de matrice dotée de dépôts est déposé, la couche de matrice étant constituée d'un matériau plus élastique que les dépôts et en particulier de Si₃N₄ surstoechiométrique ou hypostoechiométrique.

13. Procédé selon au moins l'une des revendications précédentes, **caractérisé en ce que** la formation de la couche fonctionnelle (18) à l'aide de la source (5) de faisceau plasma s'effectue au moins une partie du temps en rajoutant une opération CVD, une opération PCD ou une opération PACVD, en particulier pour déposer une couche de matrice amorphe, ou **en ce que** la formation de la couche fonctionnelle (18) s'effectue par une opération CVD, une opération PCD ou une opération PACVD à laquelle un dépôt à l'aide de la source (5) de faisceau plasma est ajouté au moins une partie du temps.

14. Procédé selon au moins l'une des revendications précédentes, **caractérisé en ce que** la source (5) de faisceau plasma et un dispositif de dépôt séparé, prévu pour l'opération CVD, l'opération PVD ou l'opération PACVD sont utilisés en continu, le substrat (12) étant déplacé entre la source (5) de faisceau plasma et le dispositif de dépôt.
